(19) **Europäisches Patentamt**
**European Patent Office**
**Office européen des brevets**

(11) **EP 3 167 527 B1**

(12) **EUROPÄISCHE PATENTSCHRIFT**

(45) Veröffentlichungstag und Bekanntmachung des Hinweises auf die Patenterteilung:
**19.05.2021 Patentblatt 2021/20**

(51) Int Cl.:
*H02J 3/14* (2006.01)  *H02J 3/32* (2006.01)
*H02J 3/28* (2006.01)  *H02J 3/38* (2006.01)
*H02J 3/40* (2006.01)  *H02J 13/00* (2006.01)

(21) Anmeldenummer: **15741726.2**

(22) Anmeldetag: **07.07.2015**

(86) Internationale Anmeldenummer:
**PCT/EP2015/001377**

(87) Internationale Veröffentlichungsnummer:
**WO 2016/005047 (14.01.2016 Gazette 2016/02)**

(54) **SYSTEM UND VERFAHREN ZUM BESTIMMEN DER LEISTUNG MEHRERER ELEKTRISCHER PRODUZENTEN UND VERBRAUCHER, DIE IN EINEM NETZWERK ALS VIRTUELLES KRAFTWERK BETRIEBEN WERDEN**

SYSTEM AND METHOD FOR DETERMINING THE POWER OF A PLURALITY OF ELECTRICAL PRODUCERS AND LOADS, WHICH ARE OPERATED IN A NETWORK AS A VIRTUAL POWER PLANT

SYSTÈME ET PROCÉDÉ POUR DÉTERMINER LA PUISSANCE DE PLUSIEURS PRODUCTEURS ET CONSOMMATEURS ÉLECTRIQUES FONCTIONNANT DANS UN RÉSEAU EN TANT QUE CENTRALE ÉLECTRIQUE VIRTUELLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.07.2014 DE 102014009954**

(43) Veröffentlichungstag der Anmeldung:
**17.05.2017 Patentblatt 2017/20**

(73) Patentinhaber: **LichtBlick SE**
**20359 Hamburg (DE)**

(72) Erfinder:
• **STORACE, Stefan**
**20359 Hamburg (DE)**

• **RUMMENIE, Martin**
**20359 Hamburg (DE)**
• **KÜHNER, Sebastian**
**20359 Hamburg (DE)**

(74) Vertreter: **Eisenführ Speiser**
**Patentanwälte Rechtsanwälte PartGmbB**
**Johannes-Brahms-Platz 1**
**20355 Hamburg (DE)**

(56) Entgegenhaltungen:
**EP-A1- 2 713 463      WO-A1-2011/091857**
**DE-A1-102009 043 380    DE-A1-102012 210 801**

**Beschreibung**

Die Erfindung betrifft ein System und ein Verfahren, um zeitaktuell die Leistung, insbesondere Gesamtleistung mehrerer technischer Einheiten zu bestimmen, die zum Erzeugen und/oder Verbrauchen elektrischer Energie örtlich dezentral verteilt sind und die zum Einspeisen oder Entnehmen elektrischer Energie an ein Stromversorgungsnetz angeschlossen sind und die zum Steuern des Betriebs über eine Kommunikationsverbindung mit einer Steuerzentrale verbunden sind.

WO 2011/091857 A1 offenbart ein Verfahren zum Betreiben eines elektrischen Energieversorgungsnetzes, das ein Energieautomationssystem, eine Vielzahl von Energieerzeugungsvorrichtungen und eine Vielzahl von Energieverbrauchern umfasst. Um einen möglichst umweltfreundlichen Betrieb des Energieversorgungsnetzes zu ermöglichen, ist das Energieautomationssystem über eine erste Kommunikationsvorrichtung mit den jeweiligen Energieerzeugungsanlagen zugeordneten Steuergeräten verbunden und jede Energieerzeugungsvorrichtung stellt mittels der Steuereinheit der Energieerzeugungsvorrichtung einen Umweltschadensparameter und einen aktuellen Leistungsparameter bereit, wobei der aktuelle Leistungsparameter die maximale elektrische Leistung anzeigt, die derzeit von der Energieerzeugungsvorrichtung bereitgestellt wird.

DE 10 2012 210 801 A1 offenbart ein Verfahren für den Betrieb eines Stromnetzes, mit elektrischen Energieverbrauchern, elektrischen Energielieferanten sowie als Puffer dienenden elektrochemischen Speichern, die zum Aufnehmen und Abgeben von Energie ausgebildet sind, wobei das Stromnetz eine zentrale, mit den elektrochemischen Speichern kommunizierende Steuerungseinrichtung aufweist, die einen bestimmten Betriebszustand für jeden Speicher auswählt, wobei ein Speicher in einem ersten Betriebszustand unbeschränkt Energie aufnehmen oder abgeben kann, in einem zweiten Betriebszustand eingeschränkt Energie aufnehmen oder abgeben kann und in einem dritten Betriebszustand keine Energie aufnehmen oder abgeben kann oder nur Energie aufnehmen oder abgeben kann.

Bekanntlich speisen Kraftwerke zur Energieversorgung elektrische Energie in Versorgungsnetzwerke ein, an die örtlich verteilte Verbraucher angeschlossen sind. Hierbei hat in den letzten Jahren der Grad der Kleinteiligkeit und Dezentralität sehr stark zugenommen: es werden nicht mehr nur zentrale, vom Ort des Energieverbrauchs unabhängige Kraftwerke betrieben, sondern es kommen immer mehr technische Einheiten hinzu, welche lokal bei den Verbrauchern angesiedelt sind und elektrische Energie einerseits ins Netz einspeisen und andererseits aus diesem entnehmen. Dies können zum Beispiel Solarzellen sein, die den Verbraucher mit Strom versorgen und dann überschüssigen Strom entweder lokal in Batterien speichern oder in das Versorgungsnetz einspeisen, aber auch lokale Biogasanlagen oder Generatoren, die z. B. mit Diesel oder Gas betrieben werden und auch der Wärmeversorgung dienen (z. B. Blockheizkraftwerke).

Eine Möglichkeit, diese dezentralen elektrischen Einheiten wirtschaftlich zu betreiben, stellt eine Organisationsform dar, die oftmals (und im Folgenden) als "virtuelles Kraftwerk" bezeichnet wird: Die Intelligenz des virtuellen Kraftwerks steuert die elektrischen Einheiten im Rahmen vorhandener Freiheitsgrade. Hierbei müssen gewisse Restriktionen der Einheiten berücksichtigt werden (z.B. Sicherstellung der Wärmeversorgung bei Blockheizkraftwerken). Unter anderem zu diesem Zweck sind die elektrischen Einheiten kommunikativ über eine Kommunikationsverbindung wie eine Datenleitung mit einer Steuerzentrale verbunden. Als elektrische Einheiten im vorliegenden Zusammenhang kommen (wie zum Teil schon erwähnt) z. B. Blockheizkraftwerke, Photovoltaikanlagen, Batterien (auch mobil montierte Batterien z. B. in elektrisch angetriebenen Fahrzeugen, die z. B. zum Laden lokal angeschlossen sind), Wärmepumpen, Nachtspeicheröfen, Windkraftanlagen oder Notstromaggregate in Betracht.

Zum Beispiel, um die auf diese Weise dezentral erzeugte elektrische Energie effizient zu verwerten, ist es für den Betreiber bedeutungsvoll, Parameter und insbesondere auch den Gesamtbetrag der momentan von "seinen" technischen Einheiten in die Versorgungsnetze eingespeisten und/oder verbrauchten Energie möglichst genau zu kennen. Dies ist insbesondere im Markt für Regelenergie relevant, wo bislang das Erfordernis bestand, über die Kommunikationsverbindungen im Sekundentakt Messwerte von jeder der technischen Einheiten an die Steuerzentrale zu übertragen und zu diesem Zweck im Sekundentakt die erforderlichen Werte wie beispielsweise die eingespeiste Leistung zu messen und zur Übertragung bereitzustellen.

Der vorliegenden Erfindung liegt die Aufgabe zu Grunde, ein in ihrer Effizienz verbessertes System und Verfahren zu schaffen, um zeitaktuell die Leistung, und insbesondere auch die Gesamtleistung mehrerer technischer Einheiten zu bestimmen, die zur Erzeugung, zur Speicherung oder zum Verbrauch elektrischer Energie örtlich verteilt und an ein Stromversorgungsnetz angeschlossen sind und die zum Steuern des Betriebs über eine Kommunikationsverbindung mit einer Steuerzentrale verbunden sind. Diese Aufgabe wird von einem System mit den Merkmalen des Anspruchs und von einem Verfahren mit den Merkmalen des Anspruchs 3 gelöst. Bevorzugte Ausgestaltungen sind in den Unteransprüchen angegeben.

Das erfindungsgemäße System und Verfahren richten sich darauf, zeitaktuell die Leistung, und insbesondere auch die Gesamtleistung mehrerer technischer Einheiten zu bestimmen. Die technischen Einheiten sind zur Erzeugung und/oder zur Speicherung und/oder zum Verbrauch elektrischer Energie örtlich verteilt. Zum Einspeisen oder Entnehmen elektrischer Energie sind die technischen Einheiten an ein Stromversorgungsnetz angeschlossen. Um den Betrieb zu steuern, sind die technischen Einheiten über eine Kommunikationsverbindung mit einer Steuerzentrale verbunden.

Erfindungsgemäß wird in dem Verfahren in einem Datenspeicher in der Steuerzentrale für jede der technischen Einheiten ein Leistungswert gespeichert, der von der technischen Einheit zu erwarten ist und der zuvor ermittelt wurde. Für diese Vorermittlung wird später ein erfindungsgemäß bevorzugtes Verfahren beschrieben. Um nun die Leistung und insbesondere auch die Gesamtleistung der technischen Einheiten zu bestimmen, sendet ein Triggersignalgeber der jeweiligen technischen Einheiten jedes Mal, wenn sich bei einer technischen Einheit ein zuvor definierter Betriebszustand ändert, ein Signal an die Steuerzentrale. Ein Rechner in der Steuerzentrale berechnet dann gemäß den Triggersignalen aus den gespeicherten Leistungswerten die momentane Gesamtleistung der im Betrieb befindlichen technischen Einheiten (insbesondere zeitaktuell), indem er den Leistungswert einer technischen Einheit, die am Triggersignal erkennbar ihren Betriebspunkt ändert, bei der Berechnung des Gesamtleistungswertes entsprechend berücksichtigt.

Entsprechend weist das erfindungsgemäße System einen Datenspeicher in der Steuerzentrale auf, der darauf eingerichtet ist, für jede der technischen Einheiten einen (zuvor ermittelten und von der technischen Einheit zu erwartenden) Leistungswert zu speichern; jeder der technischen Einheiten des erfindungsgemäßen Systems ist ein Triggersignalgeber zugeordnet, der darauf eingerichtet ist, bei jeder Betriebsänderung der jeweiligen technischen Einheit ein Signal an die Steuerzentrale zu senden; und ein Rechner vorzugsweise in der Steuerzentrale des erfindungsgemäßen Systems ist darauf eingerichtet, gemäß den Triggersignalen aus den gespeicherten Leistungswerten die momentane Gesamtleistung der im Betrieb befindlichen technischen Einheiten zu berechnen.

Ziel ist es also insbesondere, zeitaktuell die Gesamtleistung eines Pools von technischen Einheiten zu ermitteln, ohne dass aktuelle Zählerdaten vorliegen. Die Gesamtleistung wird dabei der Summe der Leistungen jeder einzelnen Anlage entsprechen und dabei innerhalb der Messgenauigkeit von geeichten Zählern liegen.

Die Vorteile dieser Erfindung sind folgende: Kostenersparnis durch nicht mehr benötigtes Sekundmessequipment für jede Anlage. Gemessene Leistungsdaten müssen nicht mehr jede Sekunde übertragen werden. Dadurch wird das Datenvolumen auf der Übertragungsstrecke erheblich vermindert sowie die Aufwände für Datenhaltung in der Zentrale deutlich reduziert, was letztendlich ebenfalls zu einer Kostenersparnis führt. Eine höhere Performance wird durch niedrigeres Datenaufkommen ermöglicht, ohne Messgenauigkeit einbüßen zu müssen.

Das Grundprinzip beruht darauf, dass aufgrund eines dezentral ermittelten Zustandes einer lokalen technischen Einheit ein zugehöriger Leistungswert ermittelt wird. Wegen geringer Anzahl der Zustandswechsel der technischen Einheit (z. B. der Wechsel von "Anlage AN" zu "Anlage AUS") kann der elektronische Kommunikationsaufwand erheblich verringert werden. Zu Grunde liegt, dass sich nur mit einem Zustandswechsel die Leistung der zugehörigen technischen Einheit signifikant ändert und jedem Zustand eindeutig eine Leistung zugeordnet werden kann. Die technischen Einheiten melden jede Zustandsänderung (z. B. Betrieb/kein Betrieb) sofort selbsttätig der Steuerzentrale. Aus dem Summensignal dieser Zustände kann die derzeit erbrachte Gesamtleistung errechnet werden. Wird das Verfahren im Rahmen der Erbringung von Sekundärregelleistung eingesetzt, ergibt sich die Höhe der Sekundärregelleistung aus der Gesamtleistung abzüglich der am Spotmarkt vermarkteten Leistung.

Sekundärregelleistung (SRL) hat derzeit einen wöchentlichen Ausschreibungszeitraum, sodass bei einer Teilnahme am SRL-Markt die angebotene bzw. bezuschlagte Leistung vom SRL-Anbieter über eine komplette Woche angeboten und vorgehalten werden muss. Die Woche unterteilt sich dabei in einen HT (Werktags 8-20Uhr) und in einen NT Bereich (Werktags 20-8Uhr und Samstags, Sonn- und Feiertags 0-24Uhr). Man unterscheidet zudem je zwischen positiver (Einspeisung oder Lastreduzierung) und negativer SRL (verringerte Einspeisung oder Lasterhöhung). Unabhängig vom SRL-Gebot muss die ohne einen SRL-Abruf erzeugte oder verbrauchte elektrische Arbeit bewirtschaftet bzw. vermarktet werden. Dies kann z.B. am sogenannten Spotmarkt, DayAhead oder Intraday erfolgen. Erhält man als Anbieter z.B. mit einem BHKW als technischer Einheit einen positiven SRL-Abruf, so erhöht der Anbieter spätestens innerhalb von 5 Minuten seine Einspeiseleistung um den abgerufenen SRL-Betrag und erzeugt damit entsprechend mehr als die ursprünglich am Spotmarkt vermarktete Leistung. Die Differenz aus (zustandsbasierter) Gesamtleistung und am Spotmarkt vermarkteter Energie beschreibt dann die erbrachte SRL bzw. SRA (Sekundärregelarbeit).

Als besonderer Vorteil der Erfindung sei nochmals hervorgehoben, dass es nicht wie bisher erforderlich ist, die Momentanleistung der technischen Einheiten des Systems oder "Pools" fortlaufend (üblicherweise im Sekundentakt) zu messen und fortlaufend im Sekundentakt von jeder einzelnen der technischen Einheiten an die Steuerzentrale zu übermitteln. Es genügt stattdessen, das Senden des Zustands-Triggersignals (nur zum Zeitpunkt der Zustandsänderung der technischen Einheit) und dessen Überwachung und Verarbeitung in der Steuerzentrale, nämlich den vorermittelten Leistungswert des durch das Triggersignal als angeschaltet erkannten technischen Einheit bei der Berechnung des Gesamtleistungswertes des Pools zu berücksichtigen.

Der vorermittelte Leistungswert kann zentral überprüft (oder auch erstmals ermittelt) werden, indem - dann vorzugsweise in einem langsameren Zeittakt wie zum Beispiel Viertelstunden - die geleistete Arbeit jeder technischen Einheit viertelstündig (lokal) gespeichert wird (die geleistete Arbeit jeder technischen Einheit wird zum Beispiel vom lokalen "Stromzähler" üblicherweise und ohne großen Aufwand ohnehin gemessen). Wenn nun z.B. seit dem letzten AN-Triggersignal des fraglichen Blockheizkraftwerks auch das Viertelstundentriggersignal zweimal einging ohne ein zwischenzeitliches AUS-Triggersignal, kann die mittlere Leistung dieses Blockheizkraftwerks, durch Abfrage von dessen lokal gespeichertem letzten Viertelstunden-Arbeitswert dadurch berechnet werden, dass dann der Arbeitswert nur noch durch die Dauer dieses Arbeitsblocks, im Beispiel 15 Minuten, zu teilen ist.

Die Erfindung ermöglicht nicht nur das Ermitteln der zeitaktuellen Gesamtleistung, sondern auch eine Betriebssteuerung des "Pools" der technischen Einheiten. In der Betriebssteuerung erfolgt die Ansteuerung der technischen Einheiten. Ziel der Ansteuerung ist ein Gesamtleistungszielwert. Dabei werden technischen Einheiten an- oder abgeschaltet oder in ihrer Leistungsabgabe bzw. -aufnahme variiert.

Diese und weitere Vorteile und Merkmale der Erfindung werden anhand der folgenden Abbildung eines Ausführungsbeispiels der Erfindung weiter beschrieben. Darin zeigt:

Fig. 1 ein Schema eines erfindungsgemäßen Systems, in dem das erfindungsgemäße Verfahren abläuft;

Fig. 2 eine schematische Darstellung des erfindungsgemäßen System und Verfahrens zur zustandsbasierten Leistungsermittlung.

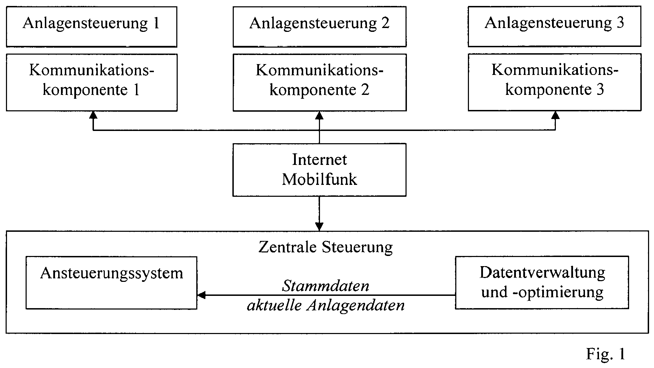

Gemäß Fig. 1 gibt die Anlagensteuerung einer jeweiligen lokalen elektrischen Einheit (z. B. BHKW 1 bis 3) über die jeweilige Kommunikationskomponente z.B. folgende für die Leistungsermittlung benötigten Daten weiter an die Steuerzentrale:

- Zeit,
- Betriebszustand, Zählerdaten (z.B. vom BHKW in der letzten Viertelstunde geleistete Arbeit)
- Fehlerzustände

Die Kommunikationskomponente ist das Verbindungsstück zwischen lokaler Anlagensteuerung und dem zentralen Steuerungssystem. Die Daten werden sowohl an die Datenverwaltung als auch an das Ansteuerungssystem geschickt.

Das Ansteuerungssystem dient der Ansteuerung und auch der zustandsbasierten Leistungsermittlung. Das Ansteuerungssystem holt sich regelmäßig aktuelle Daten aus dem Datenverwaltungssystem.

Die Datenverwaltung enthält Stamm- und dynamische Daten der Anlagen. Die Optimierung berechnet im Vorfeld eine optimierte Betriebsweise der Anlagen und greift dabei auf Stamm- und dynamische Daten zurück.

Alle Zustandswechsel einer technischen Einheit werden datenbankseitig gespeichert. Die erwartete "mittlere" Leistung wird anhand der Zustandswechsel und zwar z.B. anhand der letzten drei vollständigen Betriebsblöcke gebildet, die innerhalb der letzten vier Tage liegen. Ein Betriebsblock umfasst den Zeitraum zwischen Zustand "an" und dem darauffolgenden Zustand (ungleich "an").

Die Ermittlung der durchschnittlichen Leistung ist davon abhängig, ob und wie viele aussagekräftige Betriebsblöcke ermittelt wurden. Für jeden identifizierten aussagekräftigen Betriebsblock wird die entsprechende Leistung ermittelt. Die Ermittlung erfolgt anhand folgender Formel:

$$\text{Leistung} = \text{Arbeit} / (t_{\text{EndeBetriebsblock}} - t_{\text{AnfangBetriebsblock}})$$

| Wert | Belegung |
|---|---|
| $t_{\text{AnfangBetriebsblock}}$ | Zeitpunkt des Beginns des Betriebs-blocks (Zeitpunkt des Zustandes "an") |
| $t_{\text{EndeBetriebsblock}}$ | Zeitpunkt des Endes des Betriebsblocks (Zeitpunkt des Zustandes, der auf den Zustand "an" folgt) |
| Arbeit | die Summe der innerhalb des Betriebsblocks erzeugten Arbeit |

Existiert kein ermittelter Leistungswert, so wird die Nennleistung laut Datenblatt als durchschnittlicher Wert z. B des BHKW gesetzt (z.B. bei Neueinbauten ohne vorhandene Zustandswerte).

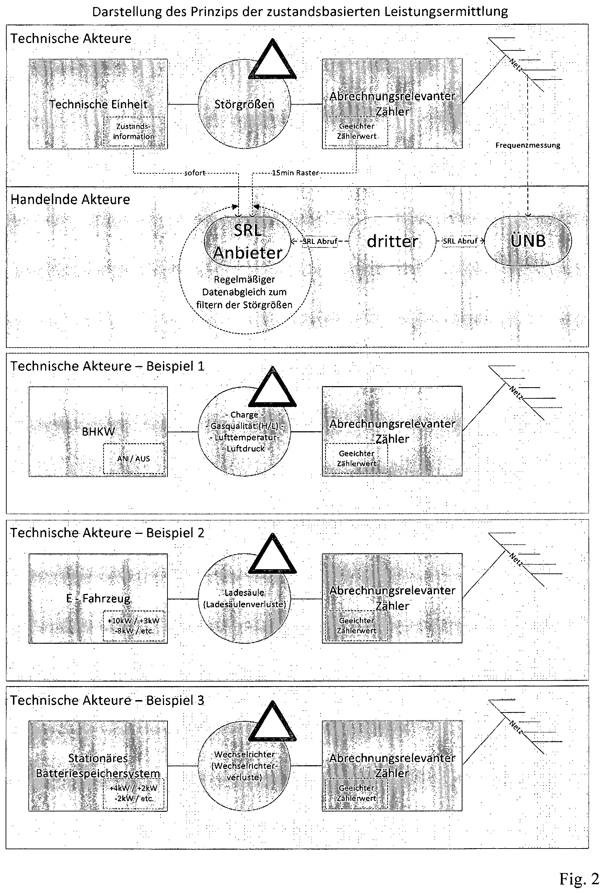

In Fig. 2 ist das erfindungsgemäße System und das Verfahren zur zustandsbasierten Leistungsermittlung skizziert.

Das skizzierte Beispiel orientiert sich dabei an der Teilnahme am SRL-Markt und gibt die allgemeinen Zusammenhänge in diesem Kontext wieder. Beispielhaft wird die Übertragung des Konzeptes auf unterschiedliche technische Akteure, die dabei zum Einsatz kommen können, dargestellt.

Man kann in dem vorliegenden Zusammenhang unterscheiden zwischen handelnden Akteuren, wie dem Übertragungsnetzbetreiber (ÜNB), gegebenenfalls einem Dritten sowie dem SRL-Anbieter, und technischen Akteuren wie der technischen Einheit selbst (z.B. BHKW oder Batterie), einem abrechnungsrelevanten Zähler sowie die SRL-Erbringung beeinflussenden Störgrößen.

Der ÜNB hat die Aufgabe, das Stromnetz stabil zu halten und ruft beim Anbieter entsprechend der Nachfrage im Netz positive oder negative SRL ab. Der Anbieter erhält über die zustandsbasierte Leistungsermittlung zeitaktuelle Informationen über die Leistung seines Pools an dezentralen technischen Einheiten und kann diese auch gegenüber dem ÜNB darstellen und für einen spontanen SRL-Abruf vom ÜNB zwecks Steuerung bzw. Regelung nutzen.

Zu Optimierungszwecken kann der Anbieter die Zustandsinformationen in einem größeren Zeitintervall z.B. mit denen eines geeichten Lastgangzählers (Leistungserfassung üblicherweise im 1/4h Raster) abgleichen und mit dieser Information Rückschüsse über die Effekte diverser Störgrößen ziehen sowie diese im Rahmen der zustandsbasierten Leistungsermittlung berücksichtigen, um die Güte der zustandsbasierten Leistungsermittlung noch weiter zu verbessern. Die zur Leistungsermittlung erfindungsgemäß vorab definierten Zustände lassen sich dabei abhängig von der eingesetzten Technologie (technischen Einheit) anpassen und definieren.

Beispiel:

- BHKW: "Zustand AN" bedeutet (Mittlere) Leistung bei Vollerbringung, z.B. 20kW und "Zustand AUS" bedeutet 0kW
- Batterie: Ladezustände werden zunächst in 2 kW Schritte (Leistungsintervalle) unterteilt und gemäß diesem Raster als Zustände an den Anbieter versendet: -4, -2, 0, +2, +4kW - sobald der Ladezustand eine dieser Grenzen passiert ("die Batterie ihren Zustand ändert"), wird ein Triggersignal an den Anbieter (die Steuerzentrale) gesendet
- Elektrofahrzeug: Vorgehen analog zu Batterie

Die Referenzpunkte für jeden Zustand lassen sich dabei auf ganz unterschiedliche Weisen ermitteln. Hat ein BHKW z.B. drei bestimmte Arbeitspunkte wie 0%, 50% und 100% Leistung, können diese als Zustände (Leistungswerte) ebenso verwendet werden, wie eine Steuerungslogik im Batteriemanagementsystem z.B. eines Elektrofahrzeugs zur Generierung von Triggersignalen zum Abgrenzen und Mitteilen, dass ein Wechsel von einem der Leistungsintervalle zu einem anderen (ein Zustandswechsel) erfolgt ist.

**Patentansprüche**

1. System, umfassend mehrere dezentrale technische Einheiten, um zeitaktuell die Leistung der technischen Einheiten zu bestimmen, die

   - zur Erzeugung und/oder zur Speicherung und/oder zum Verbrauch elektrischer Energie örtlich verteilt sind und die
   - zum Einspeisen und/oder Entnehmen elektrischer Energie an ein Stromversorgungsnetz angeschlossen sind und die
   - zum Steuern ihres Betriebs über eine Kommunikationsverbindung mit einer Steuerzentrale des Systems verbunden sind,

   **gekennzeichnet durch**

   - einen Datenspeicher in der Steuerzentrale, der darauf eingerichtet ist, für jede der technischen Einheiten einen Leistungswert oder mehrere verschiedene Leistungswerte zu speichern, und durch
   - einen Triggersignalgeber bei jeder der technischen Einheiten, der darauf eingerichtet ist, bei jedem Zustandswechsel der jeweiligen technischen Einheit zwischen dem Leistungswert und Null oder zwischen dem Leistungswert und einem anderen der Leistungswerte ein Triggersignal, das den Zustandswechsel signalisiert, an die Steuerzentrale zu senden, und durch
   - einen Rechner in der Steuerzentrale, der darauf eingerichtet ist, gemäß den Triggersignalen aus den gespeicherten Leistungswerten die momentane Leistung mindestens einer im Betrieb befindlichen technischen Einheit zu berechnen.

2. System nach dem vorhergehenden Anspruch, **dadurch gekennzeichnet, dass**

   - der Triggersignalgeber bei jeder der technischen Einheiten darauf eingerichtet ist, bei jedem Zustandswechsel der jeweiligen technischen Einheit zwischen einem Leistungsintervall und Null oder zwischen einem Leistungsintervall und einem anderen Leistungsintervall ein Triggersignal, das den Zustandswechsel signalisiert, an die Steuerzentrale zu senden, und dass

- der Rechner in der Steuerzentrale darauf eingerichtet ist, gemäß den Triggersignalen aus den gespeicherten Leistungswerten, die jeweils einem Leistungsintervall zugeordnet sind, die momentane Leistung mindestens einer im Betrieb befindlichen technischen Einheit zu berechnen.

3. Verfahren, um zeitaktuell die Leistung mehrerer dezentraler technischer Einheiten zu bestimmen, die

- zur Erzeugung und/oder zur Speicherung und/oder zum Verbrauch elektrischer Energie örtlich verteilt sind und die
- zum Einspeisen und/oder Entnehmen elektrischer Energie an ein Stromversorgungsnetz angeschlossen sind und die
- zum Steuern ihres Betriebs über eine Kommunikationsverbindung mit einer Steuerzentrale verbunden sind,

**dadurch gekennzeichnet, dass**

- in einem Datenspeicher in der Steuerzentrale für jede der technischen Einheiten ein Leistungswert oder mehrere verschiedene Leistungswerte gespeichert wird, und dass
- ein bei jeder der technischen Einheiten befindlicher Triggersignalgeber bei jedem Zustandswechsel der jeweiligen technischen Einheit zwischen dem Leistungswert und einem anderen der Leistungswerte ein Triggersignal, das den Zustandswechsel signalisiert, an die Steuerzentrale sendet, und dass
- ein Rechner in der Steuerzentrale gemäß den Triggersignalen aus den gespeicherten Leistungswerten die momentane Leistung mindestens einer im Betrieb befindlichen technischen Einheit berechnet.

4. Verfahren nach dem vorhergehenden Anspruch, **dadurch gekennzeichnet, dass**

- der Triggersignalgeber bei jeder der technischen Einheiten bei jedem Zustandswechsel der jeweiligen technischen Einheit zwischen einem Leistungsintervall und Null oder zwischen einem Leistungsintervall und einem anderen Leistungsintervall ein Triggersignal, das den Zustandswechsel signalisiert, an die Steuerzentrale sendet, und dass
- der Rechner in der Steuerzentrale gemäß den Triggersignalen aus den gespeicherten Leistungswerten, die jeweils einem Leistungsintervall zugeordnet sind, die momentane Leistung mindestens einer im Betrieb befindlichen technischen Einheit berechnet.

**Claims**

1. A system, comprising multiple decentralized technical units, for the up-to-date determination of the power of the technical units which

- are spatially distributed to generate and/or store and/or consume electrical energy, and which
- are connected to a power supply network to supply and/or remove electrical energy, and which
- are connected to a control center of the system via a communication link for the purpose of controlling their operation,

**characterized by**

- a data memory in the control center which is configured to store a power value, or multiple different power values for each of the technical units, and by
- a trigger signal generator at each of the technical units, which is configured to send, to the control center, upon every state change in the respective technical unit between the power value and zero or between the power value and another power value, a trigger signal which signals the state change, and by
- a computer in the control center which is configured to calculate from the stored power values, according to the trigger signals, the instantaneous total power of at least one technical unit in operation.

2. The system according to the previous claim, **characterized in that**

- the trigger signal generator at each of the technical units is configured to, upon every state change of the respective technical unit between a power interval and zero or between a power interval and another power interval, send a trigger signal which signals the state change to the control center, and **in that**

- the computer in the control center is configured to calculate the instantaneous power of at least one technical unit in operation, from the stored power values which are each assigned to a power interval, according to the trigger signals.

3. A method for the up-to-date determination of the power of multiple decentralized technical units which

- are spatially distributed to generate and/or store and/or consume electrical energy, and which
- are connected to a power supply network to supply and/or remove electrical energy, and which
- are connected to a control center to control their operation via a communication link,

**characterized in that**

- a power value or multiple, different power values is or are stored in a data memory in the control center for each of the technical units, and **in that**
- a trigger signal generator located at each of the technical units sends to the control center, upon every state change in the respective technical unit between the power value and another power value, a trigger signal which signals the state change, and **in that**
- a computer in the control center calculates, from the stored power values, according to the trigger signals, the instantaneous power of at least one technical unit in operation.

4. The method according to the previous claim, **characterized in that**

- the trigger signal generator at each of the technical units, upon every state change of the respective technical unit between a power interval and zero or between a power interval and another power interval, sends a trigger signal which signals the state change to the control center, and **in that**
- the computer in the control center calculates the instantaneous power of at least one technical unit in operation, from the stored power values which are each assigned to a power interval, according to the trigger signals.

**Revendications**

1. Système comprenant plusieurs unités techniques décentralisées pour définir en temps réel la puissance des unités techniques, qui

- sont réparties localement pour générer et/ou pour stocker et/ou pour consommer de l'énergie électrique et qui
- sont raccordées à un réseau d'alimentation en courant pour injecter et/ou prélever de l'énergie électrique et qui
- sont reliées à un centre de commande du système pour commander leur fonctionnement par l'intermédiaire d'une liaison de communication,

**caractérisé par**

- une mémoire de données dans le centre de commande, qui est mise au point pour stocker pour chacune des unités techniques une valeur de puissance ou plusieurs valeurs de puissance différentes, et par
- un émetteur de signaux de déclenchement pour chacune des unités techniques, qui est mis au point pour envoyer, lors de chaque changement d'état de l'unité technique respective entre la valeur de puissance et zéro ou entre la valeur de puissance et une autre des valeurs de puissance, un signal de déclenchement qui signale le changement d'état au centre de commande, et par
- un calculateur dans le centre de commande, qui est mis au point pour calculer selon les signaux de déclenchement à partir des valeurs de puissance stockées la puissance instantanée d'au moins une unité technique se trouvant en fonctionnement.

2. Système selon la revendication précédente, **caractérisé en ce que**

- l'émetteur de signaux de déclenchement pour chacune des unités techniques est mis au point pour envoyer, lors de chaque changement d'état de l'unité technique respective entre un intervalle de puissance et zéro ou entre un intervalle de puissance ou un autre intervalle de puissance, un signal de déclenchement qui signale le changement d'état au centre de commande, et que
- le calculateur dans le centre de commande est mis au point pour calculer, selon les signaux de déclenchement,

à partir des valeurs de puissance stockées qui sont associées respectivement à un intervalle de puissance, la puissance instantanée d'au moins une unité technique se trouvant en fonctionnement.

3. Procédé pour définir en temps réel la puissance de plusieurs unités techniques décentralisées, qui

- sont réparties localement pour générer et/ou pour stocker et/ou pour consommer de l'énergie électrique et qui
- sont raccordées à un réseau d'alimentation en courant pour injecter et/ou prélever de l'énergie électrique, et qui
- sont reliées à un centre de commande pour commander leur fonctionnement par l'intermédiaire d'une liaison de communication,

**caractérisé en ce que**

- une valeur de puissance ou plusieurs valeurs de puissance différentes sont stockées dans une mémoire de données dans le centre de commande pour chacune des unités techniques, et que
- un émetteur de signaux de déclenchement se trouvant dans chacune des unités techniques envoie, lors de chaque changement d'état de l'unité technique respective entre la valeur de puissance et une autre des valeurs de puissance, un signal de déclenchement qui signale le changement d'état au centre de commande, et que
- un calculateur dans le centre de commande calcule selon les signaux de déclenchement à partir des valeurs de puissance stockées la puissance instantanée d'au moins une unité technique se trouvant en fonctionnement.

4. Procédé selon la revendication précédente, **caractérisé en ce que**

- l'émetteur de signaux de déclenchement envoie, pour chacune des unités techniques, lors de chaque changement d'état de l'unité technique respective entre un intervalle de puissance et zéro ou entre un intervalle de puissance et un autre intervalle de puissance, un signal de déclenchement qui signale le changement d'état au centre de commande, et que
- le calculateur dans le centre de commande calcule selon les signaux de déclenchement à partir des valeurs de puissance stockées, qui sont associées respectivement à un intervalle de puissance, la puissance instantanée d'au moins une unité technique se trouvant en fonctionnement.

| Anlagensteuerung 1 | Anlagensteuerung 2 | Anlagensteuerung 3 |
|---|---|---|
| Kommunikations-komponente 1 | Kommunikations-komponente 2 | Kommunikations-komponente 3 |

Internet
Mobilfunk

Zentrale Steuerung

Ansteuerungssystem

*Stammdaten*
*aktuelle Anlagendaten*

Datentverwaltung
und -optimierung

Fig. 1

Darstellung des Prinzips der zustandsbasierten Leistungsermittlung

**Technische Akteure**

Technische Einheit

Zustands-information

Störgrößen

Abrechnungsrelevanter Zähler

Geeichter Zählerwert

Netz

Frequenzmessung

········sofort········· ·······15min Raster·········

**Handelnde Akteure**

SRL Anbieter

Regelmäßiger Datenabgleich zum filtern der Störgrößen

←·SRL Abruf··· dritter ·SRL Abruf → ÜNB

**Technische Akteure – Beispiel 1**

BHKW

AN / AUS

- Charge -
- Gasqualität (H/L) -
- Lufttemperatur -
- Luftdruck -

Abrechnungsrelevanter Zähler

Geeichter Zählerwert

Netz

**Technische Akteure – Beispiel 2**

E - Fahrzeug

+10kW / +3kW
-8kW / etc.

Ladesäule (Ladesäulenverluste)

Abrechnungsrelevanter Zähler

Geeichter Zählerwert

Netz

**Technische Akteure – Beispiel 3**

Stationäres Batteriespeichersystem

+4kW / +2kW
-2kW / etc.

Wechselrichter (Wechselrichter-verluste)

Abrechnungsrelevanter Zähler

Geeichter Zählerwert

Netz

Fig. 2

**EP 3 167 527 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2011091857 A1

- DE 102012210801 A1